Europäisches Patentamt

(19) European Patent Office

Office européen des brevets

(11) Veröffentlichungsnummer: **0 052 883**
**A1**

(12) # EUROPÄISCHE PATENTANMELDUNG

(21) Anmeldenummer: 81109850.8

(22) Anmeldetag: 24.11.81

(51) Int. Cl.³: **G 04 F 1/00**
**H 03 K 17/28**

(30) Priorität: 25.11.80 DE 3044235

(43) Veröffentlichungstag der Anmeldung:
02.06.82 Patentblatt 82/22

(84) Benannte Vertragsstaaten:
AT CH DE FR GB LI SE

(71) Anmelder: Quinzio, Giovanni
Eisbärenstrasse 18
D-7000 Stuttgart 80(DE)

(72) Erfinder: Quinzio, Giovanni
Eisbärenstrasse 18
D-7000 Stuttgart 80(DE)

(54) Zusatzschaltgerät.

(57) Bei diesem Zusatzschaltgerät (1) befindet sich in einem Adaptergehäuse (2) ein Zeitschalter (3). Das Zusatzschaltgerät (1) ist zwischen einer elektrischen Spannungszuführung und einem Elektroverbrauchergerät (18) angeordnet, das einen Geräteschalter (19) besitzt.

Zur Erzielung einer einfacheren und fehlerfreien Bedienung sowie zur Verbesserung der Einsatz- und Anwendungsmöglichkeiten ist ein dem Zeitschalter (3) zugehöriger Schaltkontakt (15), der mit einem Ausgangskontakt (12) des Adaptergehäuses (2) verbunden ist, einem im Adaptergehäuse (2) angeordneten elektronischen Logikteil (20, 56, 58) zugeordnet. Der Logikteil (20, 56, 58) besitzt einen Signaleingang (21) für ein über den Geräteschalter (19) vorgegebenes Uz-Signal (22). Dazu ist der Ausgangskontakt (12) des Adaptergehäuses (2) über eine Leitung (13) mit dem Signaleingang (21) des Logikteils (20, 56, 58) verbunden.

Fig. 1

EP 0 052 883 A1

Croydon Printing Company Ltd.

Giovanni Quinzio
Eisbärenstraße 18
7000 Stuttgart 80

## Zusatzschaltgerät

Die Erfindung betrifft ein Zusatzschaltgerät mit einem in einem Adaptergehäuse angeordneten Zeitschalter zur Anordnung zwischen einer elektrischen Spannungszuführung und einem durch einen Geräteschalter ein- und ausschaltbaren Elektroverbrauchergerät.

Bei einem bekannten Zusatzschaltgerät dieser Art ist im Adaptergehäuse ein Synchronmotor angeordnet und ein mit einer Zeiteinteilung versehener Stellring vorgesehen, der verschiedene Lochkränze mit einer Vielzahl von Stecklöchern aufweist, in die sogenannte Schaltstifte einzustecken sind. Für eine Schaltung eines Elektroverbrauchergerätes über das Zusatzschaltgerät sind zunächst die Schaltstifte in die entsprechend auszuwählenden Stecklöcher des Stellrings einzustecken, wobei Fehlschaltungen insbesondere bei technisch ungeübten Bedienungspersonen auftreten können. Sodann ist der Stellring durch Verdrehen auf die entsprechende Uhrzeit einzustellen, was ebenfalls zu einer Fehlbedienung führen kann und gleichfalls aufwendig und zudem umständlich ist, wobei eine zusätzliche Beeinträchtigung insbesondere dann auftreten kann, wenn zur Einstellung der Uhrzeit am Stellring kein entsprechendes Zeitanzeigegerät (Uhr) in der Nähe ist. Nach Durchführung der vorbeschriebenen Schaltsteckung sowie Uhrzeiteinstellung am Stellring und Herstellung der notwendigen Steckverbindung zwischen der Spannungszuführung und dem Elektroverbrauchergerät ist dann erst dessen Geräteschalter einzuschalten. Weiterhin wird bemängelt, daß im Falle einer Änderung der vorgewählten Zeitschaltung auf eine andere Uhrzeit jedesmal eine entsprechende Neueinstellung am Stellring bzw. einem Extraschalter am Zusatzschaltgerät von der Bedienungsperson durchzuführen ist, was ausgesprochen lästig ist, da die Bedienungsperson von ihrem Elektroverbrauchergerät stets zusätzlich zum Zusatzschaltgerät gehen und hier die entsprechende Schaltmanipulation vornehmen muß.

Demgemäß besteht die Aufgabe der Erfindung darin, ein Zusatzschaltgerät der eingangs beschriebenen Art so zu verbessern, daß eine Bedienungsvereinfachung mit weitgehend bedienungsfehlerfreier Zeitschaltung erreicht wird und von der Bedienungsperson ausschließlich eine Betätigung des Geräteschalters am jeweiligen Elektroverbrauchergerät durchzuführen ist.

Diese Aufgabe wird erfindungsgemäß dadurch gelöst, daß ein mit einem Ausgangskontakt des Adaptergehäuses verbundener Schaltkontakt des Zeitschalters einem im Adaptergehäuse angeordneten elektronischen Logikteil zugeordnet ist, der einen ein über den Geräteschalter vorgegebenes Uz-Signal aufnehmenden Signaleingang aufweist, und daß der Ausgangskontakt des Adaptergehäuses über eine Leitung mit dem Signaleingang des Logikteils verknüpft ist.

Mit der Erfindung wird der Vorteil einer äußerst einfachen und fehlbedienungssicheren Zeitschaltung über ein Zusatzschaltgerät erreicht, bei dem die Bedienungsperson zur Erzielung von Schaltvorgängen bei beliebig verschiedenen Tages- und Nachtuhrzeiten keine zusätzlichen Einstellungen durchführen muß, da aufgrund der Erfindung die Bedienungsperson wie bei einem Elektroverbrauchergerät ohne Zeitschaltungszuordnung nur den entsprechenden Geräteschalter zu bedienen hat. Wird beispielsweise der Geräteschalter am Elektroverbrauchergerät geschlossen, so fließt ein Strom durch den Verbraucher und es gelangt ein Uz-Signal über den einen mit dem Schaltkontakt verbundenen Ausgangskontakt des Zusatzgerätes durch die Leitung im Adaptergehäuse zum Signaleingang des ebenfalls im Adaptergehäuse vorgesehenen elektronischen Logikteils. Durch dieses Uz-Signal wird über den Logikteil der Schaltkontakt im Adaptergehäuse geschlossen, so daß der Verbraucherstrom fließen kann. Dabei kann vorzugsweise ein die Frequenz zählender elektronischer Zeitzähler in Gang gesetzt werden, was beispielsweise beim Fließen des Verbraucherstromes durch ein entsprechendes Ui-Signal bewirkbar ist. Nach erfolgter Vollzählung der Frequenz gemäß der vorteilhaft werksseitig voreingestellten Zeitvorgabe, die sowohl z.B. eine oder mehrere Stunden oder dergleichen als auch nur Sekundenteile umfassen kann, wird der Schaltkontakt im Adaptergehäuse geöffnet, was durch einen vom Zeitzähler bei Vollzählung ausgehenden Impuls bewirkt werden kann. Damit ist der Hauptstromkreis im Zusatzschaltgerät unterbrochen und das Elektroverbrauchergerät zuverlässig ausgeschaltet, so daß beispielsweise eine elektrische Schreibmaschine nach Beendigung der Büroarbeitszeit automatisch zwangsabgeschaltet wird, was insbesondere auch zur Erhöhung der Sicherheit außerhalb der Büroarbeitszeit über Nacht und über das Wochenende günstig ist. Beim Ausschalten des Geräteschalters am Elektroverbrauchergerät wird der Ausgangszustand wieder hergestellt und der Prozeß kann wie bereits beschrieben erneut gestartet werden, indem die Bedienungsperson ausschließlich den Geräteschalter am Elektroverbrauchergerät in die Einposition bringt. Wird der Geräteschalter des Elektroverbrauchergerätes vor dem Erreichen der Vollzählung, also vor dem Erreichen des vorgegebenen Zeitpunktes, ausgeschaltet, so bleibt der Schaltkontakt des Logikteils im Adaptergehäuse des Zusatzschaltgerätes geschlossen. Hierbei kann jedoch das Ui-Signal den Zeitzähler auf Null zurückstellen und in der Nullposition halten. Beim Wiedereinschalten des Geräteschalters am Elektroverbrauchergerät wird erneut ein Verbraucherstrom fließen, der durch eine Pegeländerung des Ui-Signals die Zählung des Zeitzählers erneut von Null beginnen läßt, so daß nach der Unterbrechung des Elektroverbrauchergerätes durch eine Abschaltung des Geräteschalters erneut und stets die volle Zeitschaltung zur Verfügung steht.

Ein weiterer Vorteil der Erfindung besteht darin, daß durch alleiniges Betätigen des Geräteschalters am Elektroverbrauchergerät die im Adaptergehäuse befindliche Zeitschaltung in verschiedene Teilzeiten beliebiger Länge mit unterschiedlichen Verbraucherruhezeiten aufgeteilt werden kann. Wird beispielsweise der Geräteschalter geschlossen, so wird über das Uz-Signal der Schaltkontakt des Logikteils geschlossen, so daß der Verbraucherstrom fließt. Durch den fließenden Verbraucherstrom wird eine Pegeländerung des Ui-Signals erreicht, die den Frequenzzähler des Zeitschalters anlaufen läßt. Wird nun vor Ablauf der eingestellten Vollzählung der Geräteschalter ausgeschaltet, so stopt die Frequenz- bzw. Zeitzählung. Der Zählerstand wird jedoch beibehalten. Beim erneuten Schließen des Geräteschalters läuft die Zählung weiter. Sie wird also praktisch dazu addiert. Nach erreichter Vollzählung, wobei das Elektroverbrauchergerät durch den Geräteschalter zuvor beliebig oft unterbrochen werden kann, wird der Schaltkontakt des Logikteils im Adaptergehäuse unterbrochen, so daß das Elektroverbrauchergerät wie vorgegeben sicherheits-

- 5 -

0052883

abgeschaltet ist. Wird danach zu jedem beliebigen Zeitpunkt der Geräteschalter ausgeschaltet, so geht der Zählerstand auf Null zurück, so daß beim erneuten Einschalten des Geräteschalters die Zeitschaltung wieder von vorne beginnen kann. Eine solche Zeitschaltung kann insbesondere vorteilhalt sein, wenn beispielsweise eine Elektroschreibmaschine während der Büroarbeitszeit eines Arbeitstages z.B. nur verhältnismäßig kurzzeitig mit größeren Unterbrechungen mehrfach benutzt wird. Vergißt die Bedienungsperson nach der Beendigung der Büroarbeitszeit das Ausschalten der Schreibmaschine an deren Geräteschalter, so wird die Schreibmaschine durch das Zusatzschaltgerät durch dessen über den elektronischen Logikteil gesteuerten Schaltkontakt bei Vollzählung der Frequenz sicherheitsabgeschaltet. Das Ui-Signal des Logikteils kann letzterem z.B. über einen vorgeschalteten Stromwandler zugeführt werden, während dem vorzugsweise rückstellbaren Zeitzähler ein Oszillator für das Frequenzsignal zugeordnet ist, der ein vorteilhaft einstellbares Potentiometer zur Frequenzeinstellung bzw. Vollzählung aufweist.

Eine solche Zeitschaltung mit sich addierenden Betriebsintervallen und beliebigen Aussetzzeiten kann insbesondere auch bei industriellen Fertigungsprozessen vorteilhaft sein. Wenn z.B. die praktische Forderung besteht, verschiedene Komponenten einer weiterzuverarbeitenden Masse od. dgl. eine genau festgelegte Zeit von z.B. einer Stunde zu mischen bzw. zu verrühren, so kann dem Rührwerk ein auf diese Mischzeit eingestelltes erfindungsgemäßes Zusatzschaltgerät zugeordnet werden. Auch hier beginnt die Inbetriebnahme ausschließlich durch Betätigung des Geräteschalters. Sofern es z.B. alle fünfzehn Minuten erforderlich sein sollte, eine weitere Komponente beizugeben bzw. eine Probe zu entnehmen und dabei das Mischwerk stillzusetzen, so kann dies ohne weiteres von der Bedienungsperson ausgeführt werden, wobei die Stillstandszeiten beliebig lang sein können. Erst bei Wiedereinschaltung des Geräteschalters läuft die nächste Teilzeit ab. Die Summe der Teilzeiten ergibt somit die gesamte Mischprozeßzeit. Das heißt, daß die Komponenten auf jeden Fall entsprechend der vorgegebenen Zeit eine Stunde lang vermischt werden.

Nach einer weiteren bevorzugten Ausführung kann es auch günstig sein, die Zeitschaltung über eine vorgegebene Zeit durchgehend laufen zu lassen, beispielsweise zum Betrieb einer Heizdecke, wobei die Heizzeit auf z.B. eine Stunde eingestellt sein kann. Die Heizdecke wird dann eingeschaltet, wenn die Bedienungsperson die Heizdecke tatsächlich benutzen will und den Geräteschalter betätigt. Schaltet die Bedienungsperson den Geräteschalter nach z.B. zwanzig Minuten ab und nach weiteren zehn Minuten wieder ein, so erfolgt noch eine Weiterheizung über eine halbe Stunde. Dann schaltet der Schaltkontakt im Adaptergehäuse des Zusatzschaltgerätes den Stromkreis sicher ab. Die Bedienungsperson kann aber auch die Heizdecke ununterbrochen bis zur Sicherheitszeitabschaltung betreiben und auch jederzeit vorher die Heizung endgültig abschalten. Vorteilhaft ist demnach bei der Erfindung besonders, daß die Zeitschaltung individuell von der Bedienungsperson am Geräteschalter vorgenommen wird, so daß nicht z.B. die Gefahr besteht, daß eine voreingestellte Betriebszeit bereits abgelaufen ist, weil die Bedienungsperson entgegen ihrer vorgesehenen Absicht bzw. sonst üblichen Gewohnheit zu einer anderen Uhrzeit das Elektroverbrauchergerät unter Einbeziehung eines Zusatzschaltgerätes benutzen will.

Weitere Vorteile und Einzelheiten der Erfindung sind der nachfolgenden Beschreibung und der Zeichnung zu entnehmen, die in schematischer Darstellung bevorzugte Ausführungsformen als Beispiel zeigt. Es stellen dar:

Fig. 1 ein erfindungsgemäßes Zusatzschaltgerät mit einer einen elektronischen Logikteil beinhaltenden Schaltung in einem Adaptergehäuse,

Fig. 2 eine Schaltungsausführung des Logikteils nach Fig.1,

Fig. 3 ein Funktions-Zeitdiagramm der Logikteilschaltung nach Fig. 2,

Fig. 4 eine andere Schaltungsausführung des Logikteils nach Fig. 1,

Fig. 5 ein Funktions-Zeitdiagramm der Logikteilschaltung nach Fig. 4,

Fig. 6 eine weitere Schaltungsausführung eines Logikteils des erfindungsgemäßen Zusatzschaltgerätes und

Fig. 7 ein Funktions-Zeitdiagramm der Logikteilschaltung nach Fig. 6.

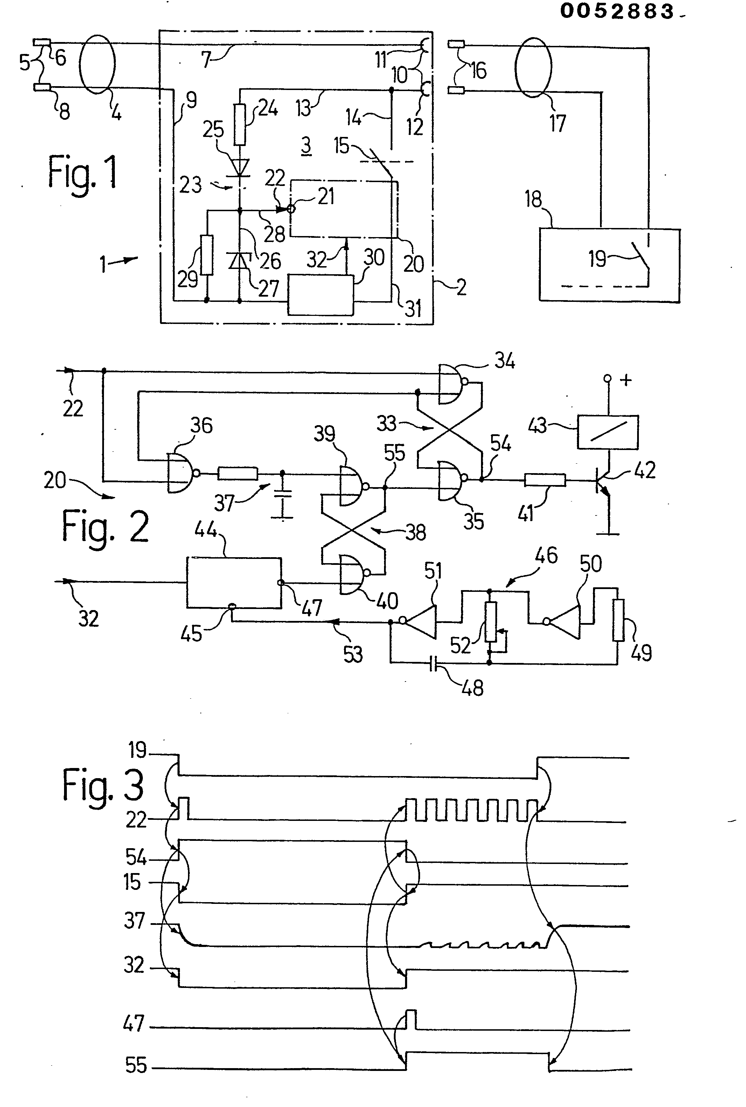

Das in der Fig. 1 dargestellte Zusatzschaltgerät 1 weist ein Adaptergehäuse 2 auf, in dem ein Zeitschalter 3 gelagert ist. Am Adaptergehäuse 2 ist als Elektrozuleitung ein flexibles Elektrokabel 4 befestigt, das mit dem Adaptergehäuse 2 somit eine Baueinheit bildet. Am freien Ende des Elektrokabels 4 ist ein Mehrpolstecker 5 angeordnet, an dessen einem Kontaktstift 6 eine Durchgangsleitung 7 befestigt ist und dessen anderem, ebenfalls als Steckerstift ausgeführten Eingangskontakt 8 ein Leitungsteil 9 des Zeitschalters 3 zugeordnet ist.

Weiterhin besitzt das Adaptergehäuse 2 ausgangsseitig eine Mehrpolsteckdose 10. Diese Mehrpolsteckdose 10 weist eine Ausgangsbuchse 11 auf, an der die Durchgangsleitung 7 angeschlossen ist. Außerdem ist an einem ebenfalls als Buchse ausgeführten Ausgangskontakt 12 der Mehrpolsteckdose 10 eine Leitung 13 des Zeitschalters 3 angeordnet, die ein Leitungsstück 14 aufweist, das zu einem Schaltkontakt 15 führt.

In die Mehrpolsteckdose 10 des Adaptergehäuses 2 werden die Steckerstifte eines Gerätesteckers 16 eingesteckt, der über ein Kabel 17 einem Elektroverbrauchergerät 18 zugehörig ist, das einen Geräteschalter 19 aufweist. Das Elektroverbrauchergerät 18 kann praktisch beliebiger Art sein und z.B. eine Schreibmaschine, eine Lampe, eine Heizdecke, eine Produktionsmaschine, ein Härteofen, ein Computergerät od. dgl. sein.

Der Zeitschalter 3 im Adaptergehäuse 2 weist einen erfindungsgemäßen elektronischen Logikteil 20 auf, dem der Schaltkontakt 15 zugeordnet ist. Dieser Logikteil 20 besitzt einen Signaleingang 21 zur Aufnahme eines Uz-Signals 22, das über die Leitung 13 zugeführt wird. Zur Sicherung des Logikteils 20 gegen eine zu hohe Spannung des Uz-Signals 22 bei einer üblichen Betriebsspannung von z.B. 220 Volt bei Haushaltsgeräten oder dergleichen, ist dem Logikteil 20 ein Begrenzungsglied 23 vorgeschaltet, welches das Uz-Signal 22 zwar durchläßt, aber seine Spannungshöhe begrenzt. Dazu weist das Begrenzungsglied 23 in der Leitung 13 einen Vorwiderstand 24 und eine Diode 25 auf, die über eine Verbindung 26 mit einer Zenerdiode 27 verbunden ist. Das Uz-Signal 22 wird dabei von einem der Leitung 13 zugehörigen Teil 28, der an der Verbindung 26 zwischen der Diode 25 und der Zenerdiode 27 abgegriffen ist, dem Signaleingang 21 des Logikteils 20 zugeführt. Außerdem ist zu erkennen, daß parallel zur Zenerdiode 27 ein Zusatzwiderstand 29 angeordnet ist. Der Zusatzwiderstand 29 ist einerseits am Leitungsteil 9 und andererseits an der Verbindung 26 zwischen der Diode 25 und der Zenerdiode 27 angeschlossen. Weiterhin ist dem Ausführungsbeispiel der Fig. 1 zu entnehmen, daß ein Stromwandler 30 vorgesehen ist, an dem der Leitungsteil 9 angeschlossen ist. Vom Stromwandler 30 führt ein Teilstück 31 weiter zum Schaltkontakt 15. Vom Stromwandler 30 wird dem Logikteil 20 ein Ui-Signal 32 zugeführt.

Wie der Fig. 2 zu entnehmen ist, weist der elektronische Logikteil 20 einen Flip-Flop bzw. Speicherteil 33 auf, der aus zwei entsprechend miteinandergeschalteten NOR-Gattern 34,35 gebildet ist. Dem NOR-Gatter 35 des Speicherteils 33 ist ein weiteres NOR-Gatter 36 sowie ein aus einem Widerstand und einem Kondensator gebildetes RC-Glied 37 und ein weiterer Speicherteil 38, der ebenfalls aus zwei zueinandergeschalteten NOR-Gattern 39,40 besteht, vorgeschaltet. Hinter das NOR-Gatter 35 des Speicherteils 33 ist ein Widerstand 41 geschaltet, dem ein Transistor 42 nachgeordnet ist, hinter dem sich ein Relais 43 befindet. Diesem Relais 43 ist der Schaltkontakt 15 zugeordnet.

Vor dem NOR-Gatter 40 des Speicherteils 38 befindet sich ein elektronischer Zeitzählerteil 44, in den das Ui-Signal 32 eingeht. Außerdem ist dem Zeitzählerteil 44 an einem C-Eingang 45 ein Oszillator 46 zugeordnet und weiterhin besitzt der Zeitzählerteil 44 einen zum NOR-Gatter 40 des Speicherteils 38 führenden Vollzählsignalausgang 47.

Der Oszillator 46 weist einen Kondensator 48, einen Widerstand 49, zwei Inverter 50,51 und ein verstellbares Potentiometer 52 für die Einstellung des die Schaltzeit mitbestimmenden Frequenzsignals 53 auf, die entsprechend zueinandergeschaltet sind.

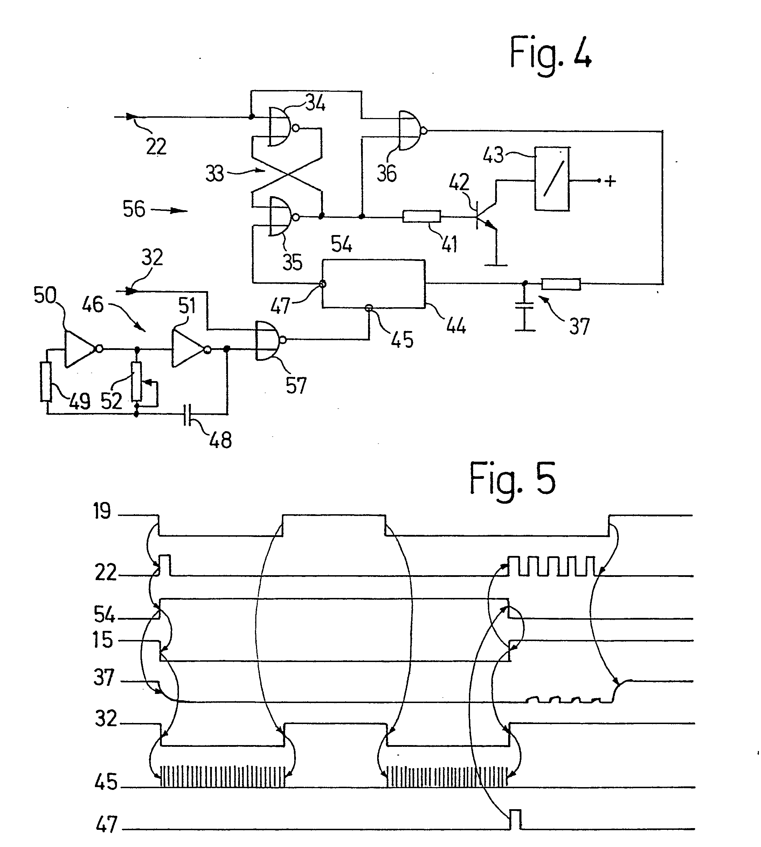

Unter Einbeziehung des in der Fig. 3 dargestellten Diagramms ist beim vorliegenden Ausführungsbeispiel folgender Funktionsablauf ersichtlich: Befindet sich der Geräteschalter 19 des Elektroverbrauchergerätes 18 wie dargestellt in seiner geöffneten Position, so ist der Schaltkontakt 15 ebenfalls offen. Es fließt somit kein Strom, so daß das Ui-Signal 32 auf "L"-Pegel (hoch) ist. Das Uz-Signal 22 befindet sich dabei "O"-Pegel (unten) und der Zeitzählerteil 44 ist im Rüstellungszustand gehalten. Der Oszillator 46 schwingt dabei mit dem Frequenzsignal 53, das durch das Potentiometer 52 veränderbar ist. Dieses Frequenzsignal 53 kann nicht in den Zeitzählerteil 44 einwirken, solange kein Strom durch das Elektroverbrauchergerät 18 fließt und somit das rückstellende Ui-Signal 32 auf "L"-Pegel ist.

Beim Schließen des Geräteschalters 19 fließt ein Strom über die Leitung 13 durch den Vorwiderstand 24, die Diode 25 und die Zenerdiode 27, so daß das spannungsbegrenzte Uz-Signal 22 gebildet ist, welches den Speicherteil 33 (Flip-Flop) setzt, wodurch dessen Q1-Ausgang 54 auf "L"-Pegel gelangt. Durch den leitenden Transistor 42 zieht das Relais 43 an, so daß der Schaltkontakt 15 schließt und der Verbraucherstrom fließen kann. Der Verbraucherstrom bewirkt, daß das Ui-Signal 32 auf "O"-Pegel geht. Damit beginnt die Zählung des Frequenzsignals 53 durch den Zeitzählerteil 44. Die Zählung der Frequenz kann so lange fortgesetzt werden, bis die Vollzählung, die der vorgewählten Zeit von z.B. ein oder zwei Stunden entspricht, erreicht ist. Nach dem Erreichen der Vollzählung tritt am Vollzählsignalausgang 47 des Zeitzählerteils 44 ein positiver Impuls auf, der den Speicherteil 38 (Flip-Flop) setzt und über den Q2-Ausgang 55 den Speicherteil 33 zurücksetzt, so daß der Transistor 42 gesperrt wird. Dadurch fällt das Relais 43 ab und der Schaltkontakt 15 wird geöffnet. Dadurch geht das Ui-Signal 32 auf "L"-Pegel und das Frequenzsignal 53 am C-Eingang 45 des Zeitzählerteils 44 wird gesperrt. Das Uz-Signal 22 wird im Takt mit der Netzfrequenz erzeugt, gelangt aber nicht zur Rückstellung des Flip-Flop 38, da die Zeitkonstante RC größer ist. Beim Ausschalten des Geräteschalters 19 geht das Uz-Signal 22 auf "O"-Pegel, das Signal RC geht auf "L"-Pegel und das Flip-Flop 38 wird zurückgesetzt. Damit ist der Ausgangszustand wieder hergestellt und der Prozeß kann von vorne gestartet werden.

Im Falle eines vorzeitigen Öffnens des Geräteschalters 19 bleibt der Schaltkontakt 15 geschlossen. Das Ui-Signal 32 wird dabei den Zeitzählerteil 44 auf Null zurückstellen und auf Null halten, solange das Ui-Signal 32 besteht. Beim Wiedereinschalten des Geräteschalters 19 wird der Verbraucherstrom erneut fließen und das Ui-Signal 32 wird auf "O"-Pegel gehen, so daß die Zählung von vorne beginnen kann.

Bei dem in der Fig. 4 dargestellten Logikteil 56 des erfindungsgemäßen Zusatzschaltgerätes sind entsprechend dem vorbeschriebenen Ausführungsbeispiel für gleiche Teile gleiche Bezugszeichen eingesetzt worden. Es ist zu erkennen, daß nicht zwei, sondern nur ein Speicherteil 33 (Flip-Flop) vorhanden ist. Außerdem ist sichtbar, daß zwischen dem Oszillator 46 und dem C-Eingang 45 des Zeitzählerteils 44 ein NOR-Gatter 57 angeordnet ist, über das das Ui-Signal 32 zugeführt wird.

Unter Einbeziehung des in der Fig. 5 dargestellten Diagramms ist folgender Funktionsablauf erkennbar: Solange der Geräteschalter 19 und der Schaltkontakt 15 offen sind, ist das Ui-Signal 32 auf "L"-Pegel und das Uz-Signal 22 ist auf "0"-Pegel. Das Flip-Flop 33 ist zurückgesetzt und der Q1-Ausgang 54 befindet sich auf "0"-Pegel. Der "L"-Pegel des Ui-Signals 32 verhindert, daß die Oszillatorfrequenz im Zeitzählerteil 44 wirksam werden kann.

Beim Schließen des Geräteschalters 19 fließt ein Strom durch den Vorwiderstand 24, die Diode 25 und die Zenerdiode 27, so daß das spannungsbegrenzte Uz-Signal 22 erzeugt wird, welches das Flip-Flop 33 setzt und den Q1-Ausgang 54 auf "L"-Pegel bringt, so daß durch den leitenden Transistor 42 das Relais 43 anzieht und den Schaltkontakt 15 schließt, so daß der Verbraucherstrom fließen kann.

Der Verbraucherstrom bewirkt, daß das Ui-Signal 32 auf "0"-Pegel fällt. Damit kann das Frequenzsignal 53 des Oszillators 46 in den Zeitzählerteil 44 gelangen, so daß der Zeitablauf beginnt. Eine Ausschaltung des Geräteschalters 19 hat zur Folge, daß die Zählung gestopt wird. Dabei wird der Zählerstand jedoch beibehalten. Beim erneuten Einschalten des Geräteschalters 19 wird die Zählung weiter geführt. Es kann beliebig oft und lange unterbrochen werden. Die einzelnen Betriebszeitintervalle werden bis zur Vollzählung addiert. Bei Erreichung der Vollzählung tritt am Vollzählsignalausgang 47 des Zeitzählerteils 44 ein positiver Impuls auf, der das Flip-Flop 33 zurücksetzt. Damit werden der Transistor 42 und das Relais 43 abgeschaltet. Dabei wird das Uz-Signal 22 nochmals erzeugt. Es kann aber nicht den Zeitzählerteil 44 zurücksetzen, weil es durch das RC-Glied 37 gedämpft wird. Das Rücksetzen des Zeitzählerteils 44 erfolgt erst beim Ausschalten des Geräteschalters 19 nach erfolgeter Vollzählung, so daß dabei wieder die Anfangsbedingungen hergestellt sind.

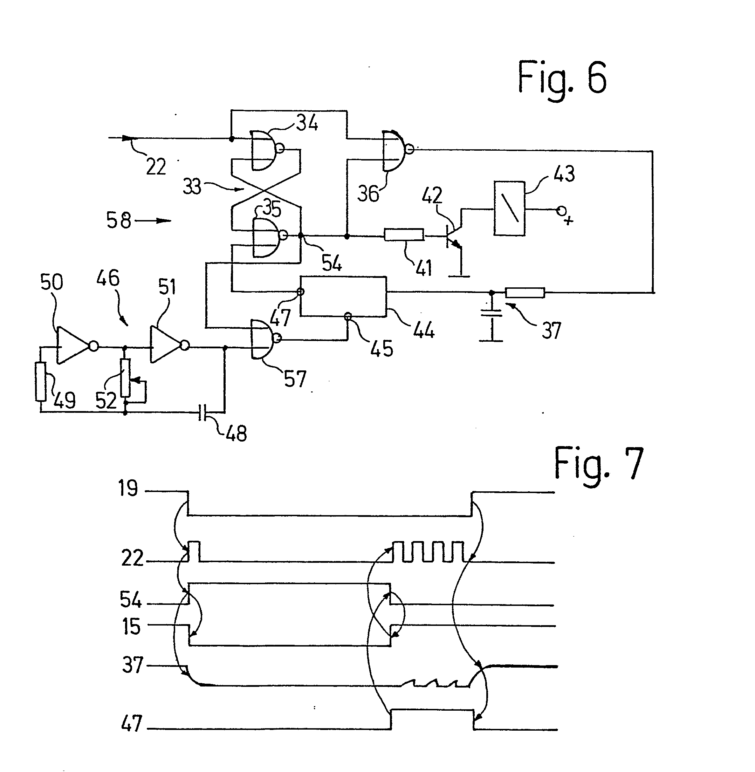

Auch bei dem in der Fig. 6 dargestellten Ausführungsbeispiel des elektronischen Logikteils 58 des erfindungsgemäßen Zusatzschaltgerätes sind wie zuvor für gleiche Teile gleiche Bezugszeichen eingesetzt worden. Hierbei wird deutlich, daß im Gegensatz zu den vorbeschriebenen Ausführungsbeispielen kein zusätzliches Ui-Signal eingegeben wird, so daß praktisch auch ein Stromwandler eingespart wird und insgesamt somit eine besonders kostengünstige Ausführung möglich ist.

Unter Einbeziehung des in der Fig. 7 dargestellten Diagramms ist folgender Funktionsablauf zu erkennen: Beim Einschalten des Geräteschalters 19 fließt ein Strom durch das Begrenzungsglied 23, so daß das spannungsbegrenzte Uz-Signal 22 den Speicherteil 33 setzt, so daß über den auf "L"-Pegel gebrachten Q1-Ausgang 54, den leitenden Transistor 42 und das Relais 43 der Schaltkontakt 15 geschlossen wird und der Verbraucherstrom fließen kann. Dadurch wird bewirkt, daß die Oszillatorfrequenz in den Zeitzählerteil 44 gelangt und die eingestellte Zeit abzulaufen beginnt. Nach erfolgter Vollzählung wird über den Vollzählsignalausgang 47 ein positiver Impuls zum Flip-Flop 33 geleitet, der diesen zurücksetzt. Dadurch werden der Transistor 42 sowie das Relais 43 abgeschaltet, so daß kein Verbraucherstrom fließt. Das Uz-Signal 22 wird dabei nochmals erzeugt, kann aber den Zähler aufgrund der Dämpfung durch das RC-Glied 37 nicht zurücksetzen. Die Dämpfungsauflösung und Rücksetzung des Zählers erfolgt erst beim Ausschalten des Geräteschalters 19 nach abgeschlossener Vollzählung. Bei dieser Ausführungsform ist es möglich, im Bereich der vorgegebenen Zeitspanne das Elektroverbrauchergerät 18 über den Geräteschalter 19 beliebig oft ein- oder auszuschalten. Dabei läuft die Zählung stets weiter. Das heißt, daß also auch die Stillstandszeit des Elektroverbrauchergerätes 18 bis zur eingestellten Vollzählung durchgehend gezählt wird.

Es liegt selbstverständlich im Rahmen der Erfindung, statt des in den Ausführungsbeispielen angegebenen Relais 43 einen Elektronikschalter wie z.B. einen Triac einzusetzen. Weiterhin ist es bei speziellen Anwendungsfällen im Rahmen der Erfindung liegend auch möglich, das Potentiometer für die Zeitvorgabe separat z.B. zentralisiert mit weiteren Potentiometern weiterer Zusatzschaltgeräte an Produktionsmaschinen in einem Überwachungsraum bzw. Steuerraum od. dgl. zusammenzufassen, so daß die jeweiligen Bedienungspersonen an den verschiedenen Produktionsmaschinen keine unbefugten Veränderungen am Produktionsablauf vornehmen können.

Giovanni Quinzio
Eisbärenstraße 18
7000 Stuttgart 80

Patentansprüche
================

1. Zusatzschaltgerät mit einem in einem Adaptergehäuse angeordneten Zeitschalter zur Anordnung zwischen einer elektrischen Spannungszuführung und einem durch einen Geräteschalter ein- und ausschaltbaren Elektroverbrauchergerät, dadurch gekennzeichnet, daß ein mit einem Ausgangskontakt (12) des Adaptergehäuses (2) verbundener Schaltkontakt (15) des Zeitschalters (3) einem im Adaptergehäuse (2) angeordneten elektronischen Logikteil (20,56, 58) zugeordnet ist, der einen ein über den Geräteschalter (19) vorgegebenes Uz-Signal (22) aufnehmenden Signaleingang (21) aufweist, und daß der Ausgangskontakt (12) des Adaptergehäuses (2) über eine Leitung (13) mit dem Signaleingang (21) des Logikteils (20,56,58) verknüpft ist.

2. Zusatzschaltgerät nach Anspruch 1, dadurch gekennzeichnet, daß dem Signaleingang (21) des Logikteils (20,56,58) im Adaptergehäuse (2) ein das Uz-Signal (22) durchlassendes Begrenzungsglied (23) vorgeordnet ist.

3. Zusatzschaltgerät nach einem der vorstehenden Ansprüche, dadurch gekennzeichnet, daß das Begrenzungsglied (23) vor dem Logikteil (20,56,58) im Adaptergehäuse (2) einen Vorwiderstand (24), eine Diode (25) und eine Zenerdiode (27) aufweist.

0052883

4. Zusatzschaltgerät nach einem der vorstehenden Ansprüche, dadurch gekennzeichnet, daß ein.am Signaleingang (21) des Logikteils (20,56,58) mündender Teil (28) der Leitung (13) an einer Verbindung (26) zwischen der Diode (25) und der Zenerdiode (27)des Begrenzungsgliedes (23) abgegriffen ist.

5. Zusatzschaltgerät nach einem der vorstehenden Ansprüche, dadurch gekennzeichnet, daß der Zenerdiode (27) des Begrenzungsgliedes (23) ein Zusatzwiderstand (29) parallel zugeordnet ist, der einerseits an einem Leitungsteil (9) eines dem Ausgangskontakt (12) zugehörigen Eingangskontaktes (8) des Adaptergehäuses (2) und andererseits an der Verbindung (26) zwischen der Diode (25) und der Zenerdiode (27) angeschlossen ist.

6. Zusatzschaltgerät nach einem der vorstehenden Ansprüche, dadurch gekennzeichnet, daß der Eingangskontakt (8) des den Logikteil (20,56,58) beinhaltenden Adaptergehäuses (2) einem Mehrpolstecker (5) und der Ausgangskontakt (12) einer Mehrpolsteckdose (10) zugeordnet ist.

7. Zusatzschaltgerät nach einem der vorstehenden Ansprüche, dadurch gekennzeichnet, daß zwischen dem den Eingangskontakt (8) aufweisenden Mehrpolstecker (5) und dem Adaptergehäuse (2) ein flexibles Elektrokabel (4) baueinheitlich fest angeordnet ist.

8. Zusatzschaltgerät nach einem der vorstehenden Ansprüche, dadurch gekennzeichnet, daß der Logikteil (20,56,58) im Adaptergehäuse (2) zwischen dem Signaleingang (21) des Uz-Signals (22) und dem mit dem Ausgangskontakt (12) des Adaptergehäuses (2) verbundenen Schaltkontakt (15) einen Speicherteil (33) aufweist, dem ein NOR-Gatter (36) und ein RC-Glied (37) zugeordnet ist.

9. Zusatzschaltgerät nach einem der vorstehenden Ansprüche, dadurch gekennzeichnet, daß der mit dem Ausgangskontakt (12) des Adaptergehäuses (2) verbundene Schaltkontakt (15) einem Uz-Signal (22) betätigbarem Relais (43) zugeordnet ist.

10. Zusatzschaltgerät nach einem der vorstehenden Ansprüche, dadurch gekennzeichnet, daß dem Relais (43) des Logikteils (20,56,58) hinter dem Speicherteil (33) ein Transistor (42) vorgeschaltet ist.

11. Zusatzschaltgerät nach einem der vorstehenden Ansprüche, dadurch gekennzeichnet, daß zwischen dem Speicherteil (33) und dem vor dem Relais (43) befindlichen Transistor (42) des Logikteils (20,56,58) ein Widerstand (41) angeordnet ist.

12. Zusatzschaltgerät nach einem der vorstehenden Ansprüche, dadurch gekennzeichnet, daß der Logikteil (20,56,58) im Adaptergehäuse (2) einen dem Speicherteil (33) zugeordneten elektronischen Zeitzählerteil (44) aufweist.

13. Zusatzschaltgerät nach einem der vorstehenden Ansprüche, dadurch gekennzeichnet, daß dem Zeitzählerteil (44) des Logikteils (20,56,58) an einem C-Eingang (45) ein Oszillator (46) zugeordnet ist.

14. Zusatzschaltgerät nach einem der vorstehenden Ansprüche, dadurch gekennzeichnet, daß der Oszillator (46) ein ein Frequenzsignal (53) einstellbares Potentiometer (52) aufweist.

15. Zusatzschaltgerät nach einem der vorstehenden Ansprüche, dadurch gekennzeichnet, daß zwischen dem Oszillator (46) und dem Zeitzählerteil (44) des Logikteils (56,58) ein NOR-Gatter (57) angeordnet ist.

16. Zusatzschaltgerät nach einem der vorstehenden Ansprüche, dadurch gekennzeichnet, daß ein Vollzählsignalausgang (47) des Zeitzählerteils (44) dem Speicherteil (33) zugeschaltet ist.

17. Zusatzschaltgerät nach einem der vorstehenden Ansprüche, dadurch gekennzeichnet, daß dem Logikteil (20,56) im Adaptergehäuse (2) ein dem Zeitzählerteil (44) ein Ui-Signal (32) zuführender Stromwandler (30) zugeordnet ist.

18. Zusatzschaltgerät nach einem der vorstehenden Ansprüche, dadurch gekennzeichnet, daß zwischen dem Vollzählsignalausgang (47) des Zeitzählerteils (44) und dem Speicherteil (33) des Logikteils (20) ein weiterer Speicherteil (38) angeordnet ist.

19. Zusatzschaltgerät nach einem der vorstehenden Ansprüche, dadurch gekennzeichnet, daß die Speicherteile (33,38) des Logikteils (20,56,58) im Adaptergehäuse (2) als aus je zwei entsprechend geschalteten NOR-Gattern (34,35 bzw. 39,40) gebildet sind.

Fig. 1

Fig. 2

Fig. 3

0052883

# Fig. 4

# Fig. 5

QUINZIO

Fig. 6

Fig. 7

**Europäisches Patentamt**

# EUROPÄISCHER RECHERCHENBERICHT

## EINSCHLÄGIGE DOKUMENTE

| Kategorie | Kennzeichnung des Dokuments mit Angabe, soweit erforderlich, der maßgeblichen Teile | betrifft Anspruch |
|---|---|---|
| X | EP - A - 0 002 648 (SODECO-SAIA SA) <br> * Seite 4, Zeile 1 - Seite 7, Zeile 27; Figuren * | 1,9, 12-14 |
| X | US - A - 4 104 541 (W.R. JEWELL) <br> * Figuren * | 1,6,9- 13 |
| X | FUNKSCHAU, Band 46, Heft 24, Nr. 24, November 1974, Seiten 959-960 München, DE. <br> G. PELTZ: "Langzeitgeber mit "Zeit-vervielfacher"" <br> * Seite 960, linke Spalte; Bild 10 * | 1-5,9 11-13 |
| X | US - A - 4 239 987 (P.M. HEFFERNAN) <br> * Bilder 1-3 * | 1,7 |
| X | TOUTE L'ELECTRONIQUE, Nr. 419, März 1977, Seiten 94-95 Paris, FR. <br> J.M. BRASSART: "Temporisateur universel" <br> * Bild 1 * | 1,9- 13,16, 19 |
| A | DE - A - 2 847 061 (BROWN BOVERI & CIE. A.G.) <br> * Bild 1 * | 1-5 |
| A | FR - A - 2 318 540 (J. TILLHET) | 1 |

**KLASSIFIKATION DER ANMELDUNG (Int Cl ⋅)**

G 04 F   1/00
H 03 K 17/28

**RECHERCHIERTE SACHGEBIETE (Int. Cl.³)**

G 04 F
G 04 G
H 03 K

**KATEGORIE DER GENANNTEN DOKUMENTE**

X: von besonderer Bedeutung allein betrachtet
Y: von besonderer Bedeutung in Verbindung mit einer anderen Veröffentlichung derselben Kategorie
A: technologischer Hintergrund
O: nichtschriftliche Offenbarung
P: Zwischenliteratur
T: der Erfindung zugrunde liegende Theorien oder Grundsätze
E: älteres Patentdokument das jedoch erst am oder nach dem Anmeldedatum veröffentlicht worden ist
D: in der Anmeldung angeführtes Dokument
L: aus andern Gründen angeführtes Dokument

&: Mitglied der gleichen Patentfamilie, übereinstimmendes Dokument

Der vorliegende Recherchenbericht wurde für alle Patentansprüche erstellt.

| Recherchenort | Abschlußdatum der Recherche | Prüfer |
|---|---|---|
| Den Haag | 19-02-1982 | EXELMANS |

EPA form 1503.1   06.78